# FASCICULE DE BREVET EUROPEEN

(11) **EP 2 909 870 B1**
(45) Date de publication et mention de la délivrance du brevet: **04.04.2018**
(21) Numéro de dépôt: 13783001.4
(22) Date de dépôt: 15.10.2013
(51) Int. Cl.: H01L 41/113, H02N 2/18, H01L 41/00

(54) **RECUPERATEUR D'ENERGIE**
ENERGIERÜCKGEWINNUNGSSYSTEM
ENERGY RECOVERY SYSTEM

(30) Priorité: 22.10.2012 FR 1260047
(43) Date de publication de la demande: 26.08.2015
(73) Titulaire: Commissariat à l'Energie Atomique et aux Energies Alternatives, 75015 Paris (FR); Institut Polytechnique de Grenoble, 38500 Grenoble (FR); Centre National de la Recherche Scientifique, 75016 Paris (FR)
(72) Inventeur: VIALA, Bernard, F-38360 Sassenage (FR); LEBEDEV, Gor, F-38100 Grenoble (FR); DELAMARE, Jérome, F-38000 Grenoble (FR); CUGAT, Orphée, F-38320 Poisat (FR); ZAKHAROV, Dmitry, F-38100 Grenoble (FR); GIMENO MONGE, Leticia, F-38000 Grenoble (FR)
(74) Mandataire: GIE Innovation Competence Group
(86) Numéro de dépôt international: PCT/EP2013/071480
(87) Numéro de publication internationale: WO 2014/063952

(56) Documents cités:
- EP-A1- 1 426 995
- US-A- 2 856 564
- US-A- 3 500 451
- US-A1- 2002 050 882
- US-B1- 6 995 496
- DIMITRY ZAKHAROV ET AL.: "Thermal energy conversion by coupled shape memory and piezoelectric effects", JOURNAL OF MICROMECHANICS & MICROENGINEERING, vol. 22, no. 9, 24 août 2012 (2012-08-24), page 94005, XP0020228731, cité dans la demande

## Description

L'invention concerne un récupérateur d'énergie pour la mise en oeuvre d'un générateur d'électricité.

Des systèmes auto-alimentés comme, par exemple, des réseaux de capteurs autonomes sans fil nécessitent un générateur d'électricité in situ. Ces systèmes sont souvent complexes et comprennent de nombreux éléments qui sont parfois installés hors de portée. Dans ces situations, la maintenance du système est compliquée et coûteuse si, par exemple, un remplacement de batterie déchargée devenait nécessaire. Il est donc souhaitable de ne pas remplacer la batterie pendant toute la durée de vie du système afin de réduire les coûts de maintenance et d'éliminer les déchets associés.

C'est dans ce contexte que des générateurs d'électricité équipés de récupérateur d'énergie ont été proposés. La récupération d'énergie est basée sur l'utilisation de sources d'énergie disponibles gratuitement dans l'environnement telles que la lumière, les changements de température, les vibrations ou autres, pour générer de l'électricité. Pour cette conversion, on utilise un convertisseur d'énergie.

En sortie du convertisseur d'énergie, il est souhaitable de récupérer l'énergie sous une tension utile élevée pour être facilement mise en forme par une charge alimentée par ce générateur électrique sans trop de déperdition d'énergie.

Ainsi, il a été proposé, dans la demande WO 2007/063194, d'utiliser un circuit de collecte et un dispositif de commande de ce circuit de collecte qui permettent de transférer l'énergie générée par le convertisseur vers la charge à alimenter uniquement lorsque cette énergie a atteint un seuil suffisant.

Ainsi, des récupérateurs connus d'électricité comportent :
- une source d'énergie à récupérer,
- un récupérateur d'énergie, ce récupérateur comportant :
   - un premier convertisseur équipé de première et seconde bornes de raccordement, ce premier convertisseur étant apte à convertir une variation de l'énergie à récupérer en un excédent correspondant de charges électriques sur la première borne de raccordement par rapport à la seconde borne,
   - un circuit de collecte de l'excédent de charges électriques sur la première borne de raccordement, ce circuit étant équipé :
      ▪ d'une borne de sortie par l'intermédiaire de laquelle sont délivrées les charges collectées, et
      ▪ d'un premier interrupteur commandable raccordé à la première borne de raccordement, ce premier interrupteur étant apte à commuter entre une position ouverte dans laquelle il empêche la décharge des charges électriques à travers la première borne de raccordement et une position fermée dans laquelle il autorise la décharge des charges électriques à travers la première borne de raccordement, et
   - un dispositif de commande du premier interrupteur propre à commander la commutation de cet interrupteur vers sa position fermée quand l'excédent de charges électriques présent sur la première borne de raccordement dépasse un premier seuil prédéterminé.

Comme décrit dans la demande WO 2007/063194, les interrupteurs statiques du circuit de collecte sont typiquement des transistors ou des thyristors. Il est connu d'alimenter ces interrupteurs à partir des charges électriques produites par le premier convertisseur de manière à permettre un fonctionnement autonome du récupérateur d'énergie, c'est-à-dire en utilisant seulement l'énergie à récupérer.

De l'état de la technique est également connu de US 6 522 048 B1, EP 1 426 995 A1, US3500451A, US2856564A, US6995496B1, US2002/050882A1 et de l'article de Dimitry Zakharov et al : « Thermal energy conversion by coupled shape memory and piezoelectric effects», Journal of Micromechanics & Microengineering, volume 22, n°9, 24/08/2012, page 99005.

L'invention vise à améliorer le rendement d'un tel récupérateur d'énergie. Le rendement est ici défini comme étant le rapport entre la quantité d'énergie réellement transmise à la charge à alimenter sur la quantité d'énergie produite par le premier convertisseur.

Elle a donc pour objet un récupérateur d'énergie conforme à la revendication 1.

Le déposant a découvert que lorsque la quantité d'énergie récupérable est faible et que le temps mis pour la récupérer est long, la baisse du rendement était en partie due à l'utilisation d'interrupteurs statiques dans le circuit de collecte.En effet, les transistors et thyristors ou similaires consomment de l'électricité lorsqu'ils commutent entre leur position fermée et ouverte. L'électricité consommée par les interrupteurs du circuit de collecte n'est donc pas transmise à la charge à alimenter par le générateur d'électricité. De plus, même dans la position ouverte, il existe toujours un courant de fuite dans les transistors et thyristors. Ce courant de fuite permet au premier convertisseur de se décharger en dehors des instants de commutation prévus. Ce problème de décharge du premier convertisseur par des courants de fuite est d'autant plus important que les variations de l'énergie à récupérer sont lentes et donc que la fréquence de commutation des interrupteurs est faible. Ainsi, la présence de transistors ou thyristors dans les récupérateurs d'énergie connus diminue leur rendement.

Dans le récupérateur ci-dessus, l'interrupteur commandable est un interrupteur mécanique et non pas un interrupteur statique tel qu'un transistor ou un thyristor comme dans les circuits de collecte connus. Dès lors, la commutation de cet interrupteur entre les positions ouverte et fermée ne consomme pas l'énergie électrique produite par le premier convertisseur. De plus, avec l'interrupteur mécanique il n'existe pas de courant de fuite. Le circuit de collecte peut donc être utilisé pour récupérer des charges sous une tension utile élevée même si les variations de l'énergie à récupérer sont très lentes.

Enfin, l'utilisation d'un transducteur qui transforme directement l'énergie à récupérer en un déplacement des contacts électriques du premier interrupteur limite la consommation du dispositif de commande et augmente le rendement du récupérateur.

Les modes de réalisation de ce récupérateur d'énergie peuvent comporter une ou plusieurs des caractéristiques des revendications dépendantes.

Ces modes de réalisation du récupérateur d'énergie présentent en outre les avantages suivants :
- utiliser un même transducteur pour commuter, en opposition de phase, deux interrupteurs mécaniques simplifie la réalisation du récupérateur d'énergie ;
- l'utilisation d'un levier permet d'augmenter la force d'appui entre les deux contacts électriques et donc de limiter la résistance électrique de l'interrupteur en position fermée ;
- utiliser un premier convertisseur comportant un premier transducteur électromécanique et un second transducteur apte à exercer une contrainte sur ce premier transducteur permet de générer de l'électricité même à partir de variation très lente de l'énergie à récupérer et de limiter l'encombrement du premier convertisseur ;
- utiliser en tant que second transducteur du premier convertisseur un transducteur thermomécanique permet de récupérer de l'énergie électrique à partir d'une variation de température et d'éviter d'avoir recours à des radiateurs pour imposer un gradient de température ;
- utiliser un matériau à mémoire de forme permet d'exercer des contraintes plus importantes sur le transducteur électromécanique ;
- utiliser le même transducteur thermomécanique pour le premier convertisseur et pour le dispositif de commande permet de limiter l'encombrement du récupérateur d'énergie.
- l'utilisation d'un premier et d'un second interrupteurs mécaniques raccordés entre la borne de sortie et, respectivement, les première et seconde bornes de raccordement permet de redresser la différence de potentiels entre les première et seconde bornes de raccordement du premier convertisseur en limitant le nombre de diodes utilisées et donc en limitant la consommation du circuit de collecte ;
- utiliser en tant que premier transducteur du premier convertisseur un matériau piézoélectrique permet de transformer simplement une variation de contrainte en électricité.

L'invention sera mieux comprise à la lecture de la description qui va suivre, donnée uniquement à titre d'exemple non limitatif et faite en se référant aux dessins sur lesquels :
- la figure 1 est un schéma général d'un générateur d'électricité équipé d'un récupérateur d'énergie;
- la figure 2 est une illustration schématique d'un premier mode de réalisation d'un circuit de collecte pour le récupérateur de la figure 1;
- la figure 3 est une illustration schématique d'un agencement pour commander un interrupteur magnétique utilisé dans le circuit de collecte de la figure 2 ;
- la figure 4 est une illustration schématique de l'interrupteur magnétique de la figure 3 ;
- les figures 5 à 17 sont des illustrations schématiques de différents modes de réalisation possibles d'un récupérateur d'énergie susceptible d'être utilisé dans le générateur de la figure 1 ;
- la figure 18 est une illustration schématique d'un autre mode de réalisation d'un circuit de collecte pour le récupérateur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

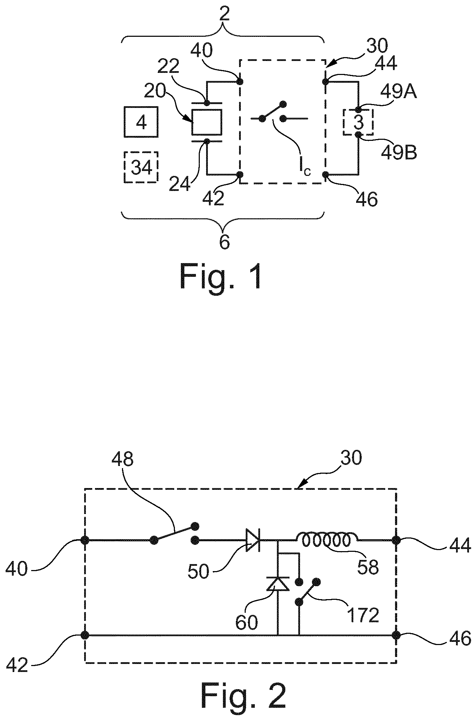

La figure 1 représente un générateur 2 d'électricité pour alimenter une charge électrique. Dans ce cas particulier, la charge électrique est une charge capable de stocker de l'énergie électrique. Par exemple, il s'agit d'un condensateur 3.

Le générateur 2 comporte une source 4 d'énergie à récupérer et un récupérateur 6 de cette énergie. Le récupérateur 6 alimente le condensateur 3 à partir de l'énergie récupérée.

La source 4 est une source d'énergie disponible gratuitement dans l'environnement du récupérateur 6.

Le récupérateur 6 comporte un convertisseur 20, un circuit 30 de collecte et un dispositif 34 de commande du circuit 30.

Le convertisseur 20 convertit une variation de l'énergie à récupérer en un excédent correspondant de charges électriques sur une borne 22 ou 24 de raccordement par rapport à l'autre borne 22 ou 24 de raccordement. Ce convertisseur 20 est capable de transformer en électricité des variations très lentes de l'énergie à récupérer. Par « variation lente », on désigne des variations dont la fréquence fondamentale est inférieure à 1 Hz ou 100 Hz.

Le circuit 30 collecte l'excédent de charges électriques sur la borne 22 ou 24 et transfert les charges électriques collectées au condensateur 3. Pour cela il est équipé d'un ou plusieurs interrupteurs mécaniques commandables Ic.

Le dispositif 34 commande les interrupteurs Ic de manière à transférer l'excédent de charges électriques généré par le convertisseur 20 vers le condensateur 3 uniquement lorsque cet excédent a atteint un seuil suffisant.

Les figures qui suivent décrivent plus en détail différents modes de réalisation possibles du récupérateur d'énergie dans le cas particulier où la source 4 d'énergie à récupérer est une source générant des variations de température du milieu ambiant dans lequel est plongé le convertisseur 20. Par exemple, il peut s'agir d'un objet chaud que l'on approche et, en alternance, que l'on éloigne du convertisseur 20 ou de la variation de température d'un objet.

Le convertisseur 20 convertit la variation de température en un excédent correspondant de charges électriques sur la borne 22 et, en alternance, sur la borne 24. Ces bornes 22 et 24 sont directement raccordées à des bornes, respectivement, 40 et 42 du circuit 30 de collecte.

De préférence, le convertisseur 20 est disposé à proximité de la source 4. Par exemple, la distance la plus courte entre le convertisseur 20 et la source 4 est inférieure à 10 cm et, de préférence, inférieure à 1 cm.

Le convertisseur 20 est aussi apte à stocker les charges électriques produites sur les bornes 22 et 24 lorsque ces bornes sont électriquement isolées de tout autre circuit électrique extérieur susceptible de lui permettre de se décharger. Ainsi, le convertisseur 20 fonctionne aussi comme un condensateur. Par exemple, en absence de raccordement à un circuit électrique extérieur, l'excédent de charges présent sur la borne 22 ou 24 varie de moins de 50 % en plus de 1 ms et, de préférence, en plus de 1 s ou 1 mn ou 1 h.

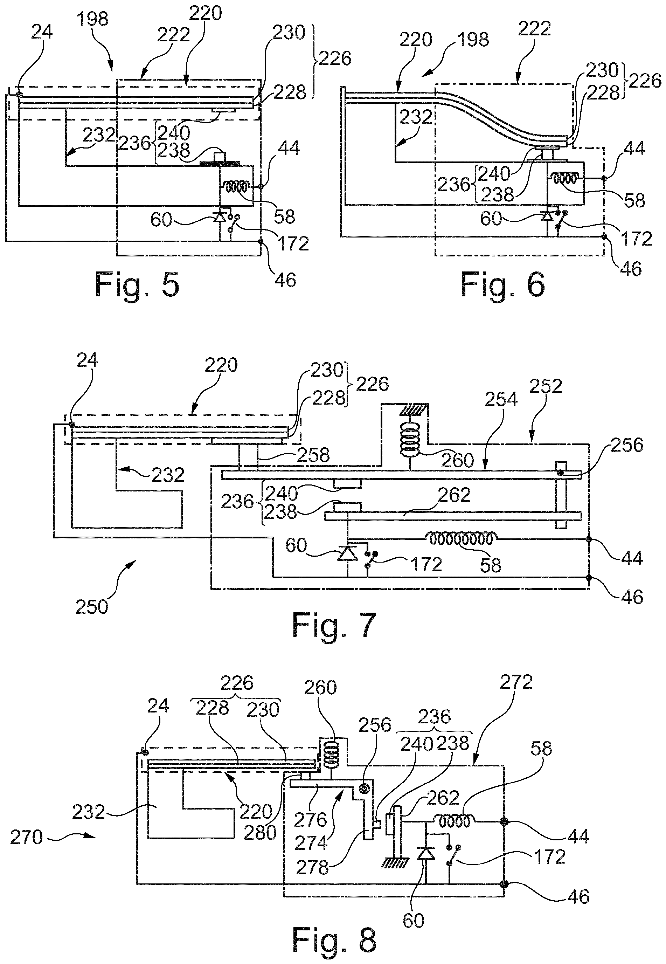

Le convertisseur 20 est décrit plus en détail en référence à la figure 5.

Le circuit 30 comprend les deux bornes 40 et 42 d'entrée directement raccordées, respectivement, aux bornes 22 et 24. Le circuit 30 comprend également deux bornes 44 et 46 de sortie directement raccordées, respectivement, à des bornes 49A et 49B du condensateur 3.

Ici, on dit que des éléments A et B sont « directement raccordés » lorsqu'il existe une liaison électrique raccordant ces éléments A et B qui ne passent pas par l'intermédiaire d'un autre composant électrique tel qu'un autre interrupteur, une autre diode ou une inductance. De plus, dans cette description, à défaut de précision contraire, le terme « raccorder » signifie « raccorder électriquement ».

Le circuit 30 est conçu pour transférer les charges électriques accumulées sur les bornes 22 et 24 vers la borne 44 de sortie.

La figure 2 représente un exemple plus détaillé de réalisation du circuit 30. A cet effet, le circuit 30 comporte un interrupteur mécanique 48 directement raccordé d'un côté à la borne 40 et de l'autre côté à l'anode d'une diode 50.

La cathode de la diode 50 est électriquement raccordée à la borne 44 par l'intermédiaire d'une inductance 58.

Le circuit 30 comporte également une diode 60 dont la cathode est directement raccordée entre la cathode de la diode 50 et l'inductance 58 et dont l'anode est directement raccordée à la borne 46. L'interrupteur 48 est apte à commuter entre une position fermée dans laquelle il conduit l'électricité et une position ouverte dans laquelle il ne conduit pas l'électricité. La commutation de cet interrupteur entre les positions fermée et ouverte est commandée par le dispositif 34 de commande. Un mode de réalisation de cet interrupteurs est décrit plus en détail en référence à la figure 5.

Le dispositif 34 commande la commutation de l'interrupteur 48 du circuit 30 pour passer, en alternance, entre :
- une position de décharge dans laquelle l'excédent de charges électriques accumulé sur la borne 22 est transféré vers la borne 44, et
- une position de repos, représentée sur la figure 2, dans laquelle la borne 22 est électriquement isolée de tout autre circuit électrique de manière à permettre l'accumulation des charges électriques sur cette borne.

Plus précisément, le dispositif 34 est conçu pour :
- commander le passage vers la position de décharge uniquement lorsque l'excédent de charges accumulé sur la borne 22 dépasse un premier seuil prédéterminé S₁, et
- commander le passage dans la position de repos tant que l'excédent de charges électriques accumulé sur la borne 22 est inférieur au seuil S₁.

A cet effet, le dispositif 34 comporte un transducteur apte à transformer directement, sans consommer l'excédent de charges électriques présent sur les bornes 22, 24, la variation de l'énergie à récupérer en une déformation mécanique qui déplace l'interrupteur 48 de sa position ouverte vers sa position fermée.

De préférence, un interrupteur commandable 172 est raccordé en parallèle de la diode 60 pour éviter la chute de tension causée par cette diode 60. A cet effet, l'interrupteur 172 est commandé de manière :
- à se fermer en même temps que la diode 60 devient passante, et en alternance
- à s'ouvrir lorsque la diode 60 est non-passante.

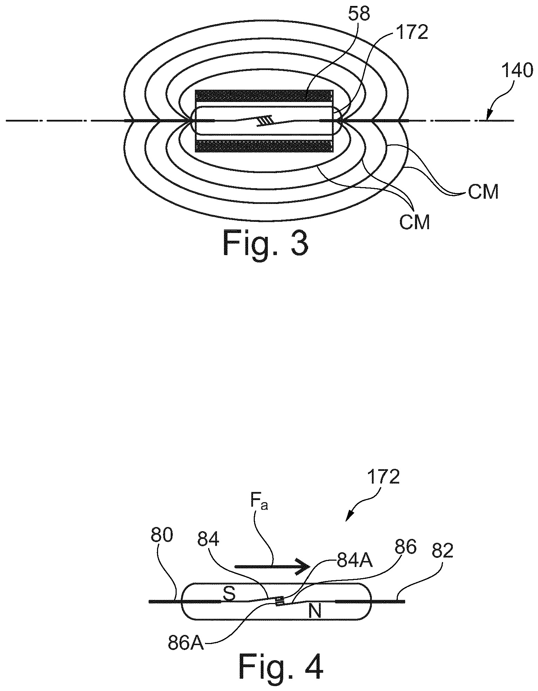

Par exemple, l'interrupteur 172 est un interrupteur magnétique normalement ouvert dont la fermeture est commandée par une bobine de commande. La bobine de commande et l'interrupteur 172 peuvent être agencés comme décrit en référence à la figure 3. Ici, la bobine de commande est la bobine 58.

La figure 3 représente plus en détail la bobine 58 et le positionnement de l'interrupteur 172 par rapport à cette bobine. Ici, la bobine 58 est bobinée autour d'un axe d'enroulement 140. L'interrupteur 172 est placé à l'intérieur des spires de la bobine 58 de manière à ce que sa direction d'actionnement soit confondue avec cet axe d'enroulement. Sur la figure 3, les lignes du champ magnétique à l'extérieure de la bobine 132 sont représentées par des lignes CM.

La figure 4 représente plus en détail un mode de réalisation possible de l'interrupteur 172. Ici, l'interrupteur 172 est un interrupteur magnétique. Plus précisément, dans le cas particulier représenté, l'interrupteur 172 est un interrupteur connu sous le terme d'interrupteur « Reed ». Il comporte deux plots électriques 80 et 82 raccordés électriquement chacun à une lame mobile respective 84 et 86. Les lames 84, 86 se terminent chacune par un contact électrique, respectivement, 84A et 86A. Les lames 84, 86 sont aptes à déplacer les contacts 84A et 86A entre :
- une position ouverte dans laquelle ils sont mécaniquement séparés l'un de l'autre par un milieu isolant pour isoler électriquement les plots 80 et 82, et
- une position fermée dans laquelle ils sont directement mécaniquement en appui l'un sur l'autre pour raccorder électriquement les plots 80 et 82.

Le milieu isolant est par exemple un gaz ou un liquide électriquement isolant ou un gaz sous très faible pression, c'est-à-dire une pression inférieure à 10⁵ Pa ou 100 Pa ou 0,1 Pa.

Les plots 80, 82 sont raccordés au reste du circuit 30.

Les lames 84 et 86 sont réalisées en matériau magnétique. Par exemple, le matériau magnétique présente une perméabilité relative supérieure à 100 ou 1000 pour une fréquence nulle du champ magnétique. Elles s'étendent essentiellement parallèlement à une direction d'actionnement commune représentée par une flèche Fₐ sur la figure 4.

Lorsque le champ magnétique, au niveau de l'interrupteur 172, atteint une configuration d'actionnement, la force exercée par ce champ magnétique permet de déplacer les contacts 84A et 86A de la position ouverte vers la position fermée. A l'inverse, en dehors d'une configuration d'actionnement, le champ magnétique au niveau de l'interrupteur est insuffisant pour garder les contacts 84A, 86A en position fermée.

Les figures 5 et 6 représentent un premier mode de réalisation du convertisseur 20, du dispositif 34 et de l'interrupteur 48. Sur cette figure, le convertisseur 20 et le dispositif 34 sont confondus et porte la référence 220. Le circuit de collecte porte la référence 222 et le récupérateur d'énergie porte la référence 198.

Le convertisseur 220 comporte une poutre 226 qui se déforme entre un état de repos, représenté sur la figure 5, et un état actif représenté sur la figure 6. A cet effet, la poutre 226 comprend un transducteur électromécanique 228 fixé sans aucun degré de liberté sous un transducteur thermomécanique 230. Le transducteur 228 est une couche en matériau piézoélectrique. Par exemple, le coefficient de couplage k de cet couche piézoélectrique est supérieur à 5 % ou 10 %. Ce coefficient de couplage est défini dans la norme ANSI/IEEE 176-1987 « ANSI/IEEE standard on piezoelectricity » ou dans les normes de la famille EN50324. Par exemple, le matériau piézoélectrique utilisé est le PZT (PbZtₓTi₁₋ₓO₃) ou autres.

Le transducteur 230 est par exemple une couche en matériau à mémoire de forme fixée directement sur une face supérieure de la couche en matériau piézoélectrique. Ici, il s'agit d'un matériau à mémoire de forme présentant un taux d'allongement au moins supérieur à 1 % en réponse à une variation de température de 10° ou de 20°C. La composition du matériau à mémoire de forme est choisie pour que la couche passe de son état déployé à son état rétracté autour d'une de température de transition T_{f} comprise entre Tₘᵢₙ et Tₘₐₓ et, de préférence, égale à (Tₘᵢₙ+Tₘₐₓ)/2 à plus ou moins 15 ou 25 % près, où Tₘᵢₙ et Tₘₐₓ sont les températures, respectivement, minimale et maximale entre lesquelles varie la température de la source 4..

Une extrémité proximale de la poutre 226 est ancrée sans aucun degré de liberté à un châssis 232. L'extrémité distale de la poutre 226 est libre.

Le circuit 222 de collecte est identique au circuit 30 de collecte sauf que :
- la diode 50 est omise pour simplifier le circuit, et
- l'interrupteur 48 porte la référence 236.

L'interrupteur 236 comporte deux contacts électriques 238 et 240 déplaçables entre une position ouverte (représentée sur la figure 5) et une position fermée (représentée sur la figure 6). Dans la position ouverte, les contacts électriques sont séparés l'un de l'autre par un milieu électriquement isolant. Ce milieu peut être un fluide électriquement isolant ou un gaz sous très faible pression. Par exemple, il s'agit d'air.

Dans la position fermée, les contacts 238 et 240 sont directement en appui l'un sur l'autre de manière à établir une continuité électrique.

Le contact 238 est fixé sans aucun degré de liberté sur le châssis 232. Le contact 240 est fixé sans aucun degré de liberté sur une face inférieure du transducteur 228.

La distance entre les contacts 238 et 240 dans l'état de repos est choisie pour que le contact 240 vienne en appui sur le contact 238 uniquement quand l'excédent de charges électriques généré par le transducteur 228 est proche de son maximum.

Le fonctionnement du récupérateur 198 est le suivant. Lorsque la température augmente, le transducteur 230 s'allonge plus que le transducteur 228. La poutre 226 se courbe alors vers sa position active. Cela crée une contrainte dans le matériau piézoélectrique du transducteur 228. En réponse, le transducteur 228 génère des charges électriques sur sa face inférieure.

En parallèle, la déformation du transducteur 230 rapproche le contact 240 du contact 238. Quand la déformation du transducteur 228 est proche de son maximum, le contact 240 vient en appui sur le contact 238. Les charges électriques générées par le transducteur 228 sont alors transférées vers la borne de sortie 44 par l'intermédiaire de l'interrupteur 236 et de l'inductance 58. Les charges électriques transférées sont, par exemple, stockées dans le condensateur 3.

Lorsque la température diminue, le transducteur 230 se déforme en sens inverse. La poutre 226 retourne alors dans l'état de repos, ce qui ramène les contacts 238, 240 vers la position ouverte.

Dans ce mode de réalisation, le dispositif de commande de la commutation de l'interrupteur 236 est le transducteur 230. Le transducteur 230 est commun à la fois au convertisseur 220 et au dispositif de commande.

La figure 7 représente un récupérateur d'énergie 250. Ce récupérateur est identique au récupérateur 198 sauf que le circuit de collecte 222 est remplacé par un circuit de collecte 252.

Le circuit de collecte 252 est identique au circuit de collecte 222 sauf qu'il comporte en plus un levier 254. Une extrémité proximale de ce levier 254 est montée en rotation autour d'un axe 256. L'axe 256 est perpendiculaire au plan dans lequel l'extrémité distale de la poutre 226 se déplace. L'axe 256 est fixé sans aucun degré de liberté au châssis 232.

L'extrémité libre du levier 254 est en appui sur une butée 258 fixée sans aucun degré de liberté sur la face inférieure du transducteur 228. La butée 258 est située à l'extrémité distale de la poutre 226. Le levier 254 est sollicité en permanence contre la butée 258 par un ressort 260.

Le contact électrique 240 de l'interrupteur 236 est fixé sans aucun degré de liberté sur le levier 254. Ici, la distance la plus courte entre le contact 240 et l'axe 256 est strictement inférieure, et de préférence au moins deux fois inférieure, à la distance la plus courte entre l'axe 256 et le point d'appui de la butée 258 sur le levier 254.

Le contact électrique 238 est fixé sans aucun degré de liberté sur une plaque 262 immobile. Typiquement, la plaque 262 est solidaire du châssis 232.

Le fonctionnement du récupérateur 250 est le suivant. Quand la température augmente, la poutre 226 se déplace de l'état de repos vers l'état actif. Ce déplacement entraîne en rotation le levier 254 autour de l'axe 256. Cette rotation rapproche le contact 240 du contact 238 jusqu'à ce que la position fermée de l'interrupteur 236 soit atteinte. Quand la position fermée est atteinte, les charges électriques générées par le transducteur 228 se décharge à travers la butée 258, le levier 254, les contacts 238 et 240 et l'inductance 58 pour atteindre la borne de sortie 44.

Le levier 254 amplifie la force d'appui du contact 240 sur le contact 238 en position fermée. La résistance de l'interrupteur 236, dans sa position fermée, est donc diminuée.

Quand la température diminue, la poutre 226 retourne vers son état de repos et le ressort 260 ramène le levier 254 dans sa position initiale. Dans la position initiale, les contacts 238 et 240 sont dans la position ouverte.

La figure 8 représente un récupérateur 270 d'énergie identique au récupérateur 250 sauf que le circuit de collecte 252 est remplacé par un circuit de collecte 272. Ce circuit de collecte 272 est identique au circuit de collecte 252 sauf que le levier 254 est remplacé par un levier 274.

Le levier 274 comporte deux bras 276 et 278 montés chacun en rotation, par une extrémité proximale, autour du même axe 256 de rotation. Ici, les bras 276 et 278 sont fixés sans aucun degré de liberté l'un à l'autre. Par exemple, ces bras 276 et 278 s'étendent principalement dans des directions orthogonales.

L'extrémité du bras 276 comporte une butée 280 en appui sur l'extrémité distale de la poutre 226. Le bras 278 comporte le contact électrique 240. Comme précédemment, la distance la plus courte entre le contact 240 et l'axe 256 est strictement inférieure à la distance la plus courte entre l'axe 256 et la butée 280 de manière à augmenter la force d'appui entre les contacts 238 et 240 dans la position fermée.

Le fonctionnement de ce récupérateur d'énergie 270 se déduit du fonctionnement du récupérateur 250.

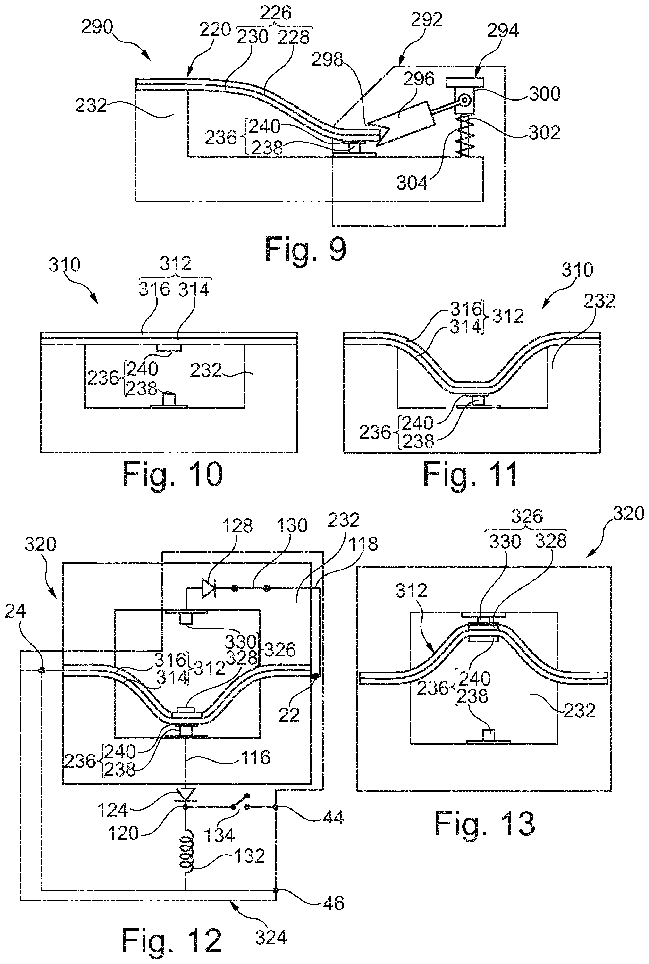

La figure 9 représente un récupérateur 290 identique au récupérateur 198 sauf que le circuit de collecte 222 est remplacé par un circuit de collecte 292. Le circuit de collecte 292 est identique au circuit de collecte 222 mais comporte en plus un mécanisme 294 de bascule transformant l'interrupteur 236 en interrupteur bistable. Un interrupteur bistable présente uniquement deux états stables à savoir la position ouverte et la position fermée. Pour cela, le mécanisme 294 permet uniquement un passage de l'état de repos à l'état actif et vice versa quand l'excédent maximal de charges électriques généré par le transducteur 228 sur l'une de ses faces est atteint.

Le mécanisme 294 est réalisé de façon conventionnelle. Par exemple, il comporte un bras 296 dont une extrémité est munie d'une fente 298, à l'intérieur de laquelle est reçue l'extrémité distale de la poutre 226. L'autre extrémité du bras 296 est montée en rotation sur un coulisseau 300. Le coulisseau 300 coulisse le long d'une tige fixe 302 qui s'étend parallèlement à la direction de déplacement de l'extrémité distale de la poutre 226. Un ressort 304 sollicite en permanence le coulisseau 300 vers le haut quand l'extrémité distale de la poutre 226 est située en bas, c'est-à-dire dans son état actif comme représenté sur la figure 22.

Pour simplifier les figures 9 à 11, la diode 60, l'inductance 58, l'interrupteur 172 et les bornes de raccordement 44 et 46 n'ont pas été représentés.

Le fonctionnement du récupérateur 290 se déduit du fonctionnement du récupérateur 198. Toutefois, le récupérateur 290 présente l'avantage de permettre le déclenchement de la commutation entre les états de repos et actif.

Les figures 10 et 11 représentent un récupérateur 310 identique au récupérateur 198 sauf que la poutre 226 est remplacée par une membrane 312. La membrane 312 est formée par un empilement d'un transducteur électromécanique 314 et d'un transducteur thermomécanique 316. Les transducteurs 314 et 316 sont par exemple identiques aux transducteurs, respectivement 228 et 230, sauf que les couches formant ces transducteurs sont conformées en forme de membrane. La périphérie de la membrane 312 est ancrée sans aucun degré de liberté au châssis 232. Cette membrane 312 est déplaçable entre un état de repos (représenté sur la figure 10) et un état actif (représenté sur la figure 11). Comme dans le mode de réalisation précédent, la membrane 312 remplit la fonction du convertisseur d'énergie à récupérer.

Le contact électrique 240 est fixé sur la face inférieure du transducteur 314 en vis-à-vis du contact 238. Ainsi, dans la position de repos, les contacts 238, 240 sont dans la position ouverte. A l'inverse, dans l'état actif, les contacts 238 et 240 sont dans la position fermée. Le dispositif de commande de la commutation de interrupteur 236 est le transducteur 316.

Le fonctionnement du récupérateur 310 est identique au fonctionnement du récupérateur 198.

Les figures 12 et 13 représentent un récupérateur 320 d'énergie. Ce récupérateur est identique au récupérateur 310 sauf que le circuit de collecte 222 est remplacé par un circuit de collecte 324.

Dans ce mode de réalisation, la membrane 312 est conformée de manière à présenter uniquement deux états stables à savoir l'état actif (représenté sur la figure 12) et l'état de repos (représenté sur la figure 13). Un exemple d'une telle conformation de la membrane 312 est décrit dans la demande US2011/0083714. Le circuit de collecte 324 comporte les mêmes bornes 44, 46 de sortie. Il comporte également deux branches 116 et 118 et un point 120 de raccordement. La branche 116 comporte un interrupteur 236 raccordé directement en série avec une diode 124. L'anode de la diode 124 est directement raccordée à l'interrupteur 236.

La branche 118 comporte un interrupteur 326 raccordé en série avec une diode 128 et un interrupteur magnétique 130. L'anode de la diode 128 est directement raccordée à l'interrupteur 326. La cathode de cette diode 128 est directement raccordée à l'interrupteur 130. L'interrupteur 130 est un interrupteur magnétique normalement fermé, c'est-à-dire que cet interrupteur 130 est dans la position fermée tant que l'amplitude du champ magnétique le long de sa direction d'actionnement est inférieure à son seuil S_{c} de commutation.

Le point 120 est électriquement raccordé par l'intermédiaire d'une bobine 132 à la bornes 46. Ce point 120 est également raccordé par l'intermédiaire d'un interrupteur 134 de libération des charges accumulées à la borne 44.

La bobine 132 génère un champ magnétique proportionnel à l'intensité du courant qui la traverse et au nombre de spires qui la compose. L'interrupteur 134 est un interrupteur magnétique normalement ouvert qui commute systématiquement en position fermée quand l'interrupteur 130 commute vers la position ouverte et vice versa. Par exemple, à cet effet, les interrupteurs 130 et 134 présentent une lame magnétique commune.

Ici, les interrupteurs 130 et 134 sont placés dans le champ magnétique généré par la bobine 132 de manière à ce que la commutation de ces interrupteurs 130 et 134 soit uniquement commandée par le champ magnétique généré par cette bobine. Un exemple de positionnement de ces interrupteurs par rapport à la bobine est décrit plus en détail en référence à la figure 3.

Ici, la direction d'actionnement, le nombre de spires de la bobine 132, la sensibilité des interrupteurs 130 et 134 est déterminée, par exemple expérimentalement, pour que ces interrupteurs 130 et 134 commutent uniquement quand l'intensité du courant traversant la bobine 132 dépasse un seuil prédéterminé S_{b}. Ce seuil S_{b} est choisi pour correspondre à un seuil S₃ de l'excédent de charges électriques présent sur la borne 22 plusieurs fois supérieur au seuil S₁. En effet, l'intensité du courant dans la bobine 132 est directement proportionnelle à l'excédent de charges électriques accumulé entre les bornes 22 et 24.

Dans ce mode de réalisation, pour simplifier le circuit, la bobine 132 est placée dans le circuit de manière à être uniquement traversée par les charges électriques allant de la borne 22 vers la borne 24. Ainsi, la borne 24 du transducteur 314 est raccordée à la borne 22 par l'intermédiaire des interrupteurs 130 et 326 et de la diode 128 mais sans passer par l'inductance 132. Typiquement, la borne 24 est directement raccordée à la face supérieure du transducteur 314 tandis que la borne 22 est directement raccordée à sa face inférieure.

L'interrupteur 326 comporte deux contacts électriques 328 et 330 disposés en vis-à-vis et déplaçables entre une position ouverte (représentée sur la figure 12) et une position fermée (représentée sur la figure 13). Le contact 328 est fixé sans aucun degré de liberté sur la face supérieure du transducteur 314. Le contact électrique 330 est fixé sans aucun degré de liberté sur le châssis 232 en vis-à-vis.

Pour simplifier la figure 13, seuls les interrupteurs 236 et 326 du circuit 324 ont été représentés.

Le fonctionnement du récupérateur 320 se déduit du fonctionnement du récupérateur 310 et des explications suivantes.

Dans la position active représentée sur la figure 12, les charges générées par la couche 314 sont transférées de la borne 22 vers la borne 24.

Par exemple, quand la température augmente, l'interrupteur 236 passe dans sa position fermée représentée sur la figure 12. Les charges stockées sur la borne 22 sont transférées par l'intermédiaire de la bobine 132 vers la borne 24. Cela crée un courant qui traverse la bobine 132.

Ainsi, dans ce mode de réalisation, le nouvel excédent de charges produit s'accumule à l'excédent transféré précédemment.

Ensuite, la température diminue. Cela provoque la commutation de l'interrupteur 236 vers sa position ouverte et la fermeture de l'interrupteur 326. Le circuit 324 passe dans une position de décharge représentée sur la figure 13. Les charges stockées et accumulées sur la borne 24 sont alors transférées vers la borne 22 par l'intermédiaire de l'interrupteur 130.

Les étapes précédentes sont réitérées plusieurs fois pour accroître l'excédent de charges stocké, en alternance, sur les bornes 22 et 24 et donc augmenter l'intensité du courant qui traverse la bobine 132 dans la position active.

En parallèle, quand l'intensité du courant qui traverse la bobine 132 atteint le seuil S_{b}, la bobine 132 commande la commutation des interrupteurs 130 et 134 vers, respectivement, leur position ouverte et fermée. Le circuit 354 passe alors dans une position de libération de l'excédent de charges électriques accumulé vers le condensateur 3. Les charges stockées par le convertisseur 312 sont alors transférées vers le condensateur 3.

Dans ce mode de réalisation, le dispositif de commande de la commutation des interrupteurs 236 et 326 est le même, c'est-à-dire le transducteur 316.

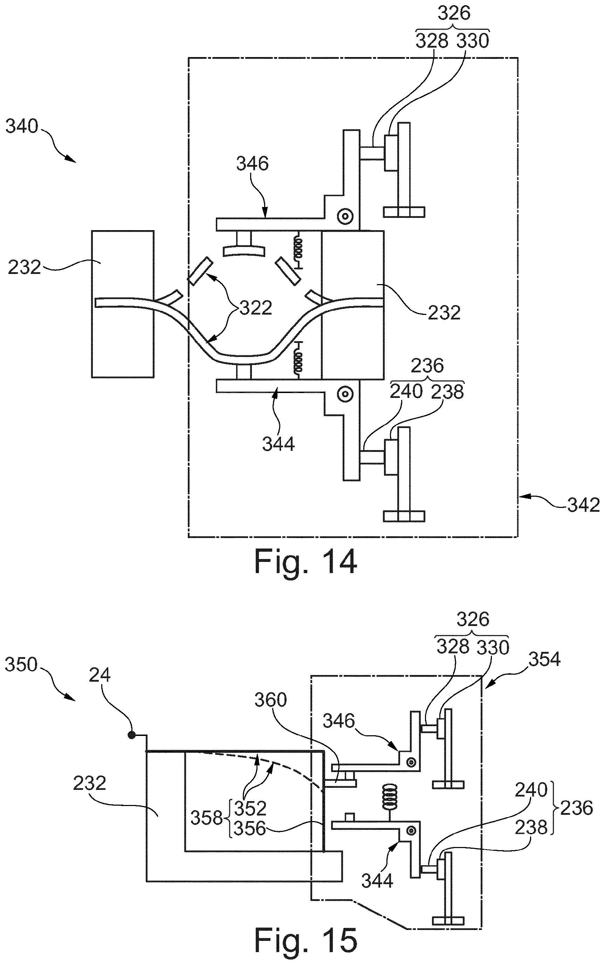

La figure 14 représente un récupérateur 340 d'énergie. Ce récupérateur est identique au récupérateur 320 sauf que le circuit de collecte 324 est remplacé par un circuit de collecte 342. Le circuit de collecte 342 est identique au circuit de collecte 324 sauf qu'il comporte en plus deux leviers 344 et 346 pour amplifier la force d'appui entre, respectivement, les contacts 238, 240 et les contacts 328, 330. Ici, les leviers 344 et 346 sont agencés chacun comme décrit en référence à la figure 8. Par conséquent, l'agencement de ces leviers n'est pas décrit ici plus en détail.

Sur la figure 14, l'état actif de la membrane 322 est représenté entre trait plein. L'état de repos est représenté en trait pointillé.

Sur cette figure 14, les interrupteurs 236 et 326 sont tous les deux représentés dans leurs positions fermées. Toutefois, lors du fonctionnement normal du récupérateur 340, lorsque l'un des interrupteurs 236 et 326 est dans sa position fermée, l'autre est dans sa position ouverte et vice versa.

Le fonctionnement du récupérateur 340 se déduit des explications données pour les récupérateurs 270 et 320.

La figure 15 représente un récupérateur 350 d'énergie identique au récupérateur 270 sauf que la poutre 222 est remplacée par une poutre 352 et que le circuit de collecte 272 est remplacé par un circuit de collecte 354.

La poutre 352 est identique à la poutre 226 sauf que le transducteur 230 est omis. Par conséquent, la poutre 352 comporte uniquement le transducteur 228, c'est-à-dire ici une couche en matériau piézoélectrique.

L'extrémité distale de la poutre 352 est raccordée à un transducteur thermomécanique 356. Ici, ce transducteur 356 est un fil tendu entre l'extrémité distale de la poutre 352 et le châssis 232. Ce fil est réalisé dans un matériau à mémoire de forme. Par exemple, il s'agit du même matériau que celui utilisé pour réaliser la couche 230.

Le transducteur 356 déplace la poutre 352 entre un état de repos, représenté entre trait plein sur la figure 15, et un état actif, représenté en trait pointillé sur la figure 15, en fonction de la température.

La combinaison de la poutre 352 et du transducteur 356 forme un convertisseur 358 d'une variation de température en charges électriques dont le fonctionnement est le suivant.

Lorsque la température augmente, le fil 356 se rétracte. La poutre 352 se courbe alors vers sa position active. Quand la température diminue, le fil 356 se détend.

Le circuit de collecte 354 est identique au circuit 342 sauf qu'il comporte une butée 360 fixée sans aucun degré de liberté sur le transducteur 356. Ainsi, la butée 360 se déplace en translation en même temps que le fil du transducteur 356 se raccourcit ou, au contraire, s'allonge entre une position extrême haute et une position extrême basse.

La butée 360 déplace en rotation le levier 344 à l'approche de sa position extrême basse. La rotation du levier 344 déplace l'interrupteur 236 vers sa position fermée. A l'inverse, la butée 360 déplace en rotation le levier 346 quand elle approche de sa position extrême haute. Cette rotation déplace l'interrupteur 326 vers sa position fermée. Dans ce mode de réalisation, le dispositif de commande des interrupteurs du circuit de collecte 354 est le transducteur 356.

Le fonctionnement du récupérateur 350 est identique au fonctionnement du récupérateur 340 sauf que le convertisseur 358 est agencé différemment.

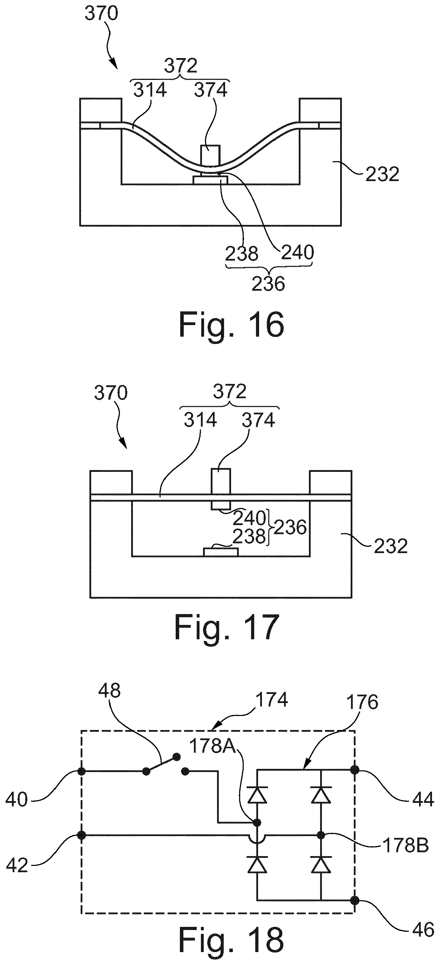

Les figures 16 et 17 représentent un récupérateur 370 identique au récupérateur 310 sauf que le convertisseur d'énergie et le dispositif de commande sont réalisés différemment. Plus précisément, la membrane 312 est remplacée par une membrane 372. La membrane 372 est identique à la membrane 312 sauf que le transducteur 316 est remplacé par un aimant permanent 374. L'aimant 374 est fixé sans aucun degré de liberté sur la face supérieure du transducteur 314 en vis-à-vis et du côté opposé à l'emplacement où est fixé le contact 240. Le moment magnétique de l'aimant 374 est dirigé vers le contact 240.

Les contacts 240 et 238 sont réalisés dans un matériau magnétique doux, c'est-à-dire un matériau dont le champ magnétique coercitif est inférieur à 10 ou 100 A.m⁻¹. Par exemple, ces contacts sont réalisés dans un alliage de fer ou de nickel ou ou de cobalt ou de permalloy.

La température de curie du contact 238 est choisie pour être située entre les extremums de la variation de température de la source d'énergie à récupérer. Par exemple, la température de curie du contact 238 est comprise entre 0 et 100° et, de préférence, entre 10 et 50°.

Pour simplifier les figures 16 et 17, les autres éléments du circuit de collecte n'ont pas été représentés. Ils sont par exemple identiques à ce qui a été décrit pour le circuit 222.

Initialement, la température de la source d'énergie à récupérer est supérieure à la température de curie du contact 238. Dans ces conditions, le contact 238 perd ses propriétés magnétiques. La membrane 372 est alors dans l'état de repos, représenté sur la figure 30. Dans cet état de repos, les contacts 238, 240 sont en position ouverte.

Lorsque la température redescend en dessous de la température de curie du contact 238, le contact 238 retrouve ses propriétés magnétiques. Il est alors attiré par l'aimant 374. Cette force d'attraction magnétique est suffisante pour déplacer la membrane 372 de l'état de repos vers l'état actif représenté sur la figure 17. Dans l'état actif, les contacts 238 et 240 sont dans la position fermée, ce qui permet aux charges générées par le transducteur 314 de se décharger vers la borne de sortie 44.

Quand la température ambiante dépasse à nouveau la température de curie du contact 238, celui-ci perd à nouveau ses propriétés magnétiques, de sorte que la membrane 372 retourne dans son état de repos par déformation élastique du transducteur 314.

Ainsi, dans ce mode de réalisation, le dispositif de commande de l'interrupteur 236 comprend l'aimant permanent 374 ainsi que le contact 238 en matériau magnétique.

La figure 18 représente un circuit 174 de collecte susceptible de remplacer le circuit 30. Le circuit 174 est identique au circuit 30 sauf que l'interrupteur 172 et la diode 60 sont remplacés par un pont de diode 176 capable de redresser le courant généré par la décharge du convertisseur 20.

Le pont de diodes 176 comprend des première et seconde branches électriquement raccordées en parallèle entre les bornes 44 et 46. La première branche comporte deux diodes raccordées en série par l'intermédiaire d'un point milieu 178A. La seconde branche comporte aussi deux diodes raccordées en série par l'intermédiaire d'un point milieu 178B. Le point milieu 178A est directement raccordé en permanence à l'un des contacts électriques de l'interrupteur 48. Le point milieu 178B est raccordé en permanence à la borne 42 du circuit de collecte, par exemple, par l'intermédiaire d'une inductance non représentée sur la figure 18.

De nombreux autres modes de réalisation sont possibles. Par exemple, le condensateur 3 peut être remplacé par une batterie. Le condensateur 3 peut aussi être remplacé par un élément électrique n'ayant pas la capacité de stocker de l'énergie électrique. Par exemple, le condensateur 3 est remplacé par une charge consommant l'énergie électrique reçue. Il peut s'agir d'une charge résistive. Dans ce dernier cas, l'inductance 58 peut être omise.

### [Variantes de la source d'énergie à récupérer]

Dans un exemple qui ne fait pas partie de la présente invention, la source d'énergie à récupérer peut être aussi un déplacement mécanique d'une pièce tel qu'un bouton poussoir. Dans ce cas, le premier convertisseur peut ne comporter que le transducteur électromécanique directement relié à cette pièce pour que le déplacement de cette pièce fasse varier la contrainte mécanique qu'elle exerce sur ce transducteur électromécanique.

La source d'énergie à récupérer peut aussi être une source de champ magnétique dont l'amplitude varie au cours du temps. Dans ce cas, le matériau à mémoire de forme utilisé dans les modes de réalisation des figures 5 à 17 pour réaliser le convertisseur et le dispositif de commande est remplacé par un matériau magnétostrictif pour provoquer la génération de charges électriques et commander les interrupteurs du circuit de collecte à partir de la variation de champ magnétique. La valeur absolue du coefficient de magnétostriction λₛ du matériau magnétostrictif est supérieure à 10 ppm (partie par million) et de préférence supérieure à 100 ou 1000 ppm. Le coefficient λₛ est défini par la relation suivante : λₛ = ΔL/L, où :
- ΔL est le taux d'élongation du matériau magnétostrictif dans une direction donnée, et
- L est la longueur de ce matériau dans cette direction en absence de champ magnétique extérieur.

Le coefficient λₛ peut être positif. Par exemple, le matériau magnétostrictif est le Terfenol-D ou le FeSiB.

Le matériau magnétostrictif du convertisseur peut aussi être un matériau à coefficient de magnétostriction négatif. Il peut aussi s'agir d'un matériau dont le coefficient de magnétostriction est isotrope ou anisotrope.

### [Variantes du convertisseur].

Le transducteur électromécanique du convertisseur 20 ne comporte pas nécessairement un matériau piézoélectrique. Par exemple, en variante, le transducteur électromécanique est réalisé à partir d'un condensateur dont la capacité varie en fonction d'un déplacement mécanique. Typiquement, le condensateur comporte deux électrodes mobiles séparées l'une de l'autre par un matériau diélectrique. Lorsque les électrodes se déplacent, la capacité du condensateur varie. Le déplacement des électrodes est actionné par :
- un matériau magnétostrictif, pour convertir une variation de champ magnétique en une variation de charges électriques, ou
- un transducteur thermomécanique, pour convertir une variation de température en une variation de charges électriques, ou
- un déplacement mécanique d'un bouton, pour convertir un déplacement mécanique en une variation de charges électriques.

Dans une mode particulier de réalisation, les électrodes du condensateur sont réalisées dans un matériau magnétostrictif. Dans ce cas, une variation de l'amplitude du champ magnétique dans une direction donnée entraîne une variation de la surface des électrodes et donc de la capacité de ce condensateur.

Dans une autre variante, on choisit pour le condensateur des électrodes standard et un diélectrique dont la permittivité varie en fonction du champ magnétique. Il peut s'agir par exemple de BiFeO₃. Dans ce cas également, une variation du champ magnétique entraîne une variation de la capacité du condensateur.

La variation de la capacité du condensateur est ensuite transformée en une génération de charges électriques par un dispositif électronique comme, par exemple, un dispositif mettant en oeuvre des électrets. La génération d'électricité à partir d'une variation de capacité et à l'aide d'électrets est par exemple décrite dans l'article suivant :
S. Boisseau, G. Despesse et A. Sylvestre, « Optimization of an electret-based energy harvester », Smart Material and Structures, 2010, 19 075015, IOP Publisching Ltd.

En variante, le transducteur 356 s'étend dans le prolongement du transducteur 352.

Le contact 238 dans le récupérateur 370 d'énergie peut aussi être réalisé dans un matériau magnétique tel qu'un aimant permanent.

L'aimant 374 peut être directement fixé sur la châssis 232 et c'est alors le contact 240 solidaire de la membrane qui possède une température de Curie comprise entre le minimum et le maximum de température de la source d'énergie à récupérer.

### [Variantes des circuits de collecte et des dispositifs de commande]

Dans le circuit de collecte 30, la diode 50 peut être omise.

Les différents modes de réalisation possibles de l'interrupteur 48 décrits en référence aux figures 5 et suivantes peuvent être utilisés pour réaliser d'autres circuits de collecte.

Les dispositifs 222, 252, 272, 292, 310 324, 342, 354 ont été décrits dans le cas particulier où ils utilisent le même transducteur magnétique ou thermomécanique que celui utilisé par le convertisseur. En variante, le dispositif de commande comprend son propre transducteur magnétique ou thermomécanique mécaniquement indépendant de celui utilisé par le convertisseur de l'énergie à récupérer. Dans ce cas, le dispositif de commande peut être dépourvu de transducteur électromécanique apte à générer des charges électriques. Par exemple, ce transducteur comporte uniquement un matériau à mémoire de forme ou un matériau magnétostrictif.

Le matériau à mémoire de forme utilisé dans les modes de réalisation des figures 5 à 17 pour réaliser le convertisseur et le dispositif de commande peut être remplacé par un matériau à fort coefficient de dilatation pour former un bilame avec la couche en matériau piézoélectrique.

Le levier utilisé pour augmenter la force d'appui des contacts l'un sur l'autre peut être remplacé par un levier qui augmente la course des contacts entre les positions ouverte et fermée. Pour cela, la distance la plus courte entre le contact mobile et l'axe de rotation du levier est choisie strictement supérieure et, de préférence au moins deux fois supérieure, à la distance la plus courte entre le point d'appui sur la poutre et l'axe de rotation.

### [Variantes d'interrupteurs]

Les interrupteurs 130, 134, 172 ou la diode 60 peuvent être remplacés par des interrupteurs électroniques tels que des transistors ou thyristors.

Quel que soit l'interrupteur mécanique considéré, les contacts électriques de cet interrupteur ne se matérialisent pas nécessairement par un plot électrique en sailli. Par exemple, le contact électrique peut aussi être une région de l'élément qui se déforme ou se déplace et qui vient en appui mécanique sur l'autre contact électrique pour établir la continuité électrique.

## Revendications

1. Un récupérateur d'énergie apte à transformer de l'énergie à récupérer, choisie dans le groupe composé d'une variation de température et d'une variation de l'amplitude d'un champ magnétique, en énergie électrique, ce récupérateur comportant :
- un premier convertisseur (20 ; 228 ; 314 ; 352) équipé de première et seconde bornes (22, 24) de raccordement, ce premier convertisseur étant apte à convertir une variation de l'énergie à récupérer en un excédent correspondant de charges électriques sur la première borne de raccordement par rapport à la seconde borne,
- un circuit (30 ; 174 ; 222 ; 252 ; 272 ; 292 ; 324 ; 342 ; 354) de collecte de l'excédent de charges électriques sur la première borne de raccordement, ce circuit étant équipé :
• d'une borne (40) de sortie par l'intermédiaire de laquelle sont délivrées les charges collectées, et
• d'un premier interrupteur commandable (48 ; 236) raccordé à la première borne de raccordement, ce premier interrupteur étant apte à commuter entre une position ouverte dans laquelle il empêche la décharge des charges électriques à travers la première borne de raccordement et une position fermée dans laquelle il autorise la décharge des charges électriques à travers la première borne de raccordement, et
- un dispositif de commande du premier interrupteur propre à commander la commutation de cet interrupteur vers sa position fermée uniquement quand l'excédent de charges électriques présent sur la première borne de raccordement dépasse un premier seuil prédéterminé,
**caractérisé en ce que** :
- le premier interrupteur est un interrupteur mécanique commandable (48 ; 236), la position fermée de l'interrupteur mécanique étant obtenue par la mise en appui d'un contact électrique directement sur un autre contact électrique de manière à établir une continuité électrique et la position ouverte étant obtenue par la séparation mécanique de ces deux contacts électriques et l'interposition entre ces deux contacts électriques d'un milieu électriquement isolant,
- le dispositif de commande comporte un transducteur thermomécanique (230 ; 316 ; 356 ; 374, 238) ou un matériau magnétostrictif apte à transformer directement, sans consommer l'excédent de charges électriques présent sur la première borne de raccordement, la variation de l'énergie à récupérer en une déformation mécanique qui déplace le premier interrupteur de sa position ouverte vers sa position fermée.

2. Le récupérateur selon la revendication 1, dans lequel
- le transducteur (230 ; 316 ; 356 ; 374, 238) du dispositif de commande est apte à se déformer entre :
• un premier état dans lequel l'excédent de charges électriques présent sur la première borne dépasse le premier seuil, et
• un second état dans lequel l'excédent de charges électriques présent sur la première borne est en-deçà du premier seuil, et
- l'un des contacts électriques (240) du premier interrupteur est mécaniquement fixé sans aucun degré de liberté à ce transducteur de manière à être déplacé de la position ouverte vers la position fermée par ce transducteur lorsque celui-ci se déforme de son second état vers son premier état.

3. Le récupérateur selon la revendication 2, dans lequel :
- le premier convertisseur (316 ; 356) est apte à convertir l'énergie à récupérer en un excédent de charges électriques sur la première borne de raccordement dépassant le premier seuil prédéterminé lorsque le transducteur est dans le premier état, et en un excédent de charges électriques sur la seconde borne de raccordement dépassant un second seuil prédéterminé lorsque le transducteur est dans le second état,
- le circuit de collecte comporte un second interrupteur mécanique (326) commandable raccordé à la seconde borne de raccordement, ce second interrupteur étant apte à commuter entre une position ouverte dans laquelle il empêche la décharge des charges électriques à travers la seconde borne de raccordement et une position fermée dans laquelle il autorise la décharge des charges électriques à travers la seconde borne de raccordement, l'un des contacts électriques du second interrupteur étant mécaniquement fixé sans aucun degré de liberté au même transducteur du dispositif de commande, de manière à être déplacé par ce même transducteur de la position ouverte vers la position fermée lorsque celui-ci se déforme du premier état vers le second état.

4. Le récupérateur selon la revendication 1, dans lequel :
- le dispositif de commande comporte un levier (254 ; 274 ; 344, 346) déplaçable en rotation autour d'un axe,
- le transducteur du dispositif de commande est en appui mécanique sur une extrémité de ce levier de manière à le déplacer en rotation lorsque le transducteur se déforme entre :
• un premier état dans lequel l'excédent de charges électriques présent sur la première borne dépasse le premier seuil, et
• un second état dans lequel l'excédent de charges électriques présent sur la première borne est en-deçà du premier seuil, et
- au moins l'un des contacts électriques (240 ; 328) du premier interrupteur est fixé sans aucun degré de liberté sur le levier en un emplacement plus proche de l'axe de rotation que l'emplacement où est en appui le transducteur, de manière à être déplacé par ce levier de la position ouverte vers la position fermée en même temps que le transducteur se déforme de son second état vers son premier état.

5. Le récupérateur selon l'une quelconque des revendications précédentes, dans lequel le premier convertisseur comporte :
- un premier transducteur électromécanique (228 ; 314 ; 352) apte à transformer une contrainte mécanique exercée sur ce transducteur électromécanique en une génération de l'excédent de charges électriques collecté par le circuit électrique de collecte, et
- un second transducteur (230 ; 316 ; 356 ; 374, 238) fixé sans aucun degré de liberté au premier transducteur électromécanique, ce second transducteur étant apte à convertir une variation de l'énergie à récupérer en une contrainte mécanique exercée sur le transducteur électromécanique.

6. Le récupérateur selon la revendication 5, dans lequel, le second transducteur est un transducteur thermomécanique (230 ; 316 ; 356 ; 374, 238) apte à transformer une variation de température en une déformation mécanique de ce second transducteur.

7. Le récupérateur selon la revendication 6, dans lequel le transducteur thermomécanique (230 ; 316 ; 356 ; 374, 238) comporte un matériau à mémoire de forme.

8. Le récupérateur selon la revendication 5 et la revendication 1, dans lequel le même transducteur (230 ; 316 ; 356 ; 374, 238) forme à la fois le second transducteur du premier convertisseur (186) et le transducteur du dispositif de commande.

9. Le récupérateur selon la revendication 5, dans lequel le transducteur électromécanique (72, 74 ; 196 ; 228 ; 314) du premier convertisseur comprend un matériau piézoélectrique.

## Patentansprüche

1. Energierückgewinnungsvorrichtung, die zurückzugewinnende Energie, die aus der Gruppe gewählt ist, die eine Temperaturänderung und eine Amplitudenänderung eines Magnetfeldes enthält, in elektrische Energie transformieren kann, wobei diese Rückgewinnungsvorrichtung Folgendes umfasst:
- einen ersten Umsetzer (20; 228; 314; 352), der mit einem ersten und einem zweiten Verbindungsanschluss (22, 24) versehen ist, wobei dieser erste Umsetzer eine Änderung der zurückzugewinnenden Energie in einen entsprechenden Überschuss elektrischer Ladungen an seinem ersten Anschluss in Bezug auf seinen zweiten Anschluss umsetzen kann,
- eine Schaltung (30; 174; 222; 252; 272; 292; 324; 342; 354) zum Sammeln überschüssiger elektrischer Ladungen an dem ersten Verbindungsanschluss, wobei diese Schaltung Folgendes umfasst:
• einen Ausgangsanschluss (40), über den die gesammelten Ladungen geliefert werden, und
• einen ersten steuerbaren Unterbrecher (48; 236), der mit dem ersten Verbindungsanschluss verbunden ist, wobei dieser erste Unterbrecher zwischen einer offenen Position, in der er die Entladung elektrischer Ladungen über den ersten Verbindungsanschluss verhindert, und einer geschlossenen Position, in der er die Entladung elektrischer Ladungen über den ersten Verbindungsanschluss zulässt, umschalten kann, und
- eine Steuervorrichtung des ersten Unterbrechers, die in der Lage ist, das Umschalten dieses Unterbrechers in seine geschlossene Position ausschließlich dann zu steuern, wenn der Überschuss elektrischer Ladungen, der an dem ersten Verbindungsanschluss vorhanden ist, einen ersten vorgegebenen Schwellenwert überschreitet,
**dadurch gekennzeichnet, dass**:
- der erste Unterbrecher ein steuerbarer mechanischer Unterbrecher (48; 236) ist, wobei die geschlossene Position des mechanischen Unterbrechers durch Abstützen eines elektrischen Kontakts direkt auf einem anderen elektrischen Kontakt, derart, dass eine elektrische Durchschaltung gebildet wird, erhalten wird und die offene Position durch die mechanische Trennung dieser beiden elektrischen Kontakte und die Einfügung eines elektrisch isolierenden Mediums zwischen diese beiden elektrischen Kontakte erhalten wird,
- die Steuervorrichtung einen thermomechanischen Wandler (230; 316; 356; 374, 238) oder ein magnetostriktives Material umfasst, die ohne Verbrauch der überschüssigen elektrischen Ladungen, die an dem ersten Verbindungsanschluss vorhanden sind, die Änderung der zurückzugewinnenden Energie in eine mechanische Verformung, die den ersten Unterbrecher aus seiner offenen Position in seine geschlossene Position verlagert, transformieren kann.

2. Rückgewinnungsvorrichtung nach Anspruch 1, wobei
- der Wandler (230; 316; 356; 374, 238) der Steuervorrichtung sich verformen kann zwischen:
• einem ersten Zustand, in dem der Überschuss elektrischer Ladungen, der an dem ersten Anschluss vorhanden ist, den ersten Schwellenwert überschreitet, und
• einem zweiten Zustand, in dem der Überschuss elektrischer Ladungen, der an dem ersten Anschluss vorhanden ist, unterhalb des ersten Schwellenwerts liegt, und
- einer der elektrischen Kontakte (240) des ersten Unterbrechers ohne jeden Freiheitsgrad an diesem Wandler mechanisch befestigt ist, derart, dass er durch diesen Wandler aus der offenen Position in die geschlossene Position verlagert wird, wenn sich dieser aus seinem zweiten Zustand in seinen ersten Zustand verformt.

3. Rückgewinnungsvorrichtung nach Anspruch 2, wobei:
- der erste Wandler (316; 356) die zurückzugewinnende Energie in einen Überschuss elektrischer Ladungen an dem ersten Verbindungsanschluss, der den ersten vorgegebenen Schwellenwert überschreitet, wenn der Wandler in dem ersten Zustand ist, und in einen Überschuss elektrischer Ladungen an dem zweiten Verbindungsanschluss, der einen zweiten vorgegebenen Schwellenwert überschreitet, wenn der Wandler in dem zweiten Zustand ist, umsetzen kann,
- die Sammelschaltung einen zweiten steuerbaren mechanischen Unterbrecher (326) umfasst, der mit dem zweiten Verbindungsanschluss verbunden ist, wobei dieser zweite Unterbrecher zwischen einer offenen Position, in der er die Entladung elektrischer Ladungen über den zweiten Verbindungsanschluss verhindert, und einer geschlossenen Position, in der er die Entladung elektrischer Ladungen über den zweiten Verbindungsanschluss zulässt, umschalten kann, wobei einer der elektrischen Kontakte des zweiten Unterbrechers ohne jeden Freiheitsgrad an demselben Wandler der Steuervorrichtung mechanisch befestigt ist, derart, dass er durch diesen Wandler aus der offenen Position in die geschlossene Position verlagert wird, wenn sich dieser aus dem ersten Zustand in den zweiten Zustand verformt.

4. Rückgewinnungsvorrichtung nach Anspruch 1, wobei:
- die Steuervorrichtung einen Hebel (254; 274; 344, 346) umfasst, der um eine Achse rotatorisch verlagerbar ist,
- der Wandler der Steuervorrichtung sich auf einem Ende dieses Hebels mechanisch abstützt, derart, dass er ihn rotatorisch verlagert, wenn der Wandler sich verformt zwischen:
• einem ersten Zustand, in dem der Überschuss elektrischer Ladungen, der an dem ersten Anschluss vorhanden ist, den ersten Schwellenwert überschreitet, und
• einem zweiten Zustand, in dem der Überschuss elektrischer Ladungen, der an dem ersten Anschluss vorhanden ist, unterhalb des ersten Schwellenwerts liegt, und
- wenigstens einer der elektrischen Kontakte (240; 328) des ersten Unterbrechers ohne jeden Freiheitsgrad an dem Hebel an einer Stelle befestigt ist, die sich näher bei der Drehachse befindet als die Stelle, an der sich der Wandler abstützt, derart, dass er gleichzeitig mit der Verformung des Wandlers aus seinem zweiten Zustand in seinen ersten Zustand durch diesen Hebel aus der offenen Position in die geschlossene Position verlagert wird.

5. Rückgewinnungsvorrichtung nach einem der vorhergehenden Ansprüche, wobei der erste Umsetzer Folgendes umfasst:
- einen ersten elektromechanischen Wandler (228; 314; 352), der eine mechanische Beanspruchung, die auf diesen elektromechanischen Wandler ausgeübt wird, in eine Erzeugung überschüssiger elektrischer Ladungen, die von der elektrischen Sammelschaltung gesammelt werden, transformieren kann, und
- einen zweiten Wandler (230; 316; 356; 374, 238), der ohne jeden Freiheitsgrad an dem ersten elektromechanischen Wandler befestigt ist, wobei dieser zweite Wandler eine Änderung der zurückzugewinnenden Energie in eine mechanische Beanspruchung, die auf den elektromechanischen Wandler ausgeübt wird, umsetzen kann.

6. Rückgewinnungsvorrichtung nach Anspruch 5, wobei der zweite Wandler ein thermomechanischer Wandler (230; 316; 356; 374, 238) ist, der eine Temperaturänderung in eine mechanische Verformung dieses zweiten Wandlers transformieren kann.

7. Rückgewinnungsvorrichtung nach Anspruch 6, wobei der thermomechanische Wandler (230; 316; 356; 374, 238) ein Material mit Formerinnerungsvermögen enthält.

8. Rückgewinnungsvorrichtung nach Anspruch 5 und Anspruch 1, wobei derselbe Wandler (230; 316; 356; 374, 238) zugleich den zweiten Wandler des ersten Umsetzers (186) und den Wandler der Steuervorrichtung bildet.

9. Rückgewinnungsvorrichtung nach Anspruch 5, wobei der elektromechanische Wandler (72, 74; 196; 228; 314) des ersten Umsetzers ein piezoelektrisches Material enthält.

## Claims

1. Energy harvester suitable for transforming energy to be harvested, chosen from the group composed of a variation in temperature and a variation in the amplitude of a magnetic field, into electrical energy, this harvester comprising:
- a first converter (20; 228; 314; 352) equipped with first and second connection terminals (22, 24), this first converter being suitable for converting a variation of the energy to be harvested into a corresponding excess of electrical charges on the first connection terminal relative to the second terminal,
- a circuit (30; 174; 222; 252; 272; 292; 324; 342; 354) for collecting the excess of electrical charges on the first connection terminal, this circuit being equipped:
• with an output terminal (40) via which the collected charges are delivered, and
• a first controllable switch (48; 236) connected to the first connection terminal, this first switch being suitable for switching between an open position in which it prevents the discharging of the electrical charges through the first connection terminal and a closed position in which it allows the discharging of the electrical charges through the first connection terminal, and
- a control device for the first switch designed to control the switching of this switch to its closed position only when the excess of electrical charges present on the first connection terminal exceeds a first predetermined threshold,
**characterized in that**:
- the first switch is a controllable mechanical switch (48; 236), the closed position of the mechanical switch being obtained by the bearing of an electrical contact directly on another electrical contact so as to establish an electrical continuity and the open position being obtained by the mechanical separation of these two electrical contacts and the interposition between these two electrical contacts of an electrically insulating medium,
- the control device comprises a thermo-mechanical transducer (230; 316; 356; 374, 238) or a magnetostrictive material suitable for directly transforming, without consuming the excess of electrical charges present on the first connection terminal, the variation of the energy to be harvested into a mechanical deformation which displaces the first switch from its open position to its closed position.

2. Harvester according to Claim 1, in which
- the transducer (230; 316; 356; 374, 238) of the control device is suitable for being deformed between:
• a first state in which the excess of electrical charges present on the first terminal exceeds the first threshold, and
• a second state in which the excess of electrical charges present on the first terminal is below the first threshold, and
- one of the electrical contacts (240) of the first switch is mechanically fixed with no degree of freedom to this transducer so as to be displaced from the open position to the closed position by this transducer when the latter is deformed from its second state to its first state.

3. Harvester according to Claim 2, in which:
- the first converter (316; 356) is suitable for converting the energy to be harvested into an excess of electrical charges on the first connection terminal exceeding the first predetermined threshold when the transducer is in the first state, and into an excess of electrical charges on the second connection terminal exceeding a second predetermined threshold when the transducer is in the second state,
- the collection circuit comprises a second controllable mechanical switch (326) connected to the second connection terminal, this second switch being suitable for switching between an open position in which it prevents the discharging of the electrical charges through the second connection terminal and a closed position in which it allows the discharging of the electrical charges through the second connection terminal, one of the electrical contacts of the second switch being mechanically fixed with no degree of freedom onto the same transducer of the control device so as to be displaced by this same transducer from the open position to the closed position when the latter is deformed from the first state to the second state.

4. Harvester according to Claim 1, in which:
- the control device comprises a lever (254; 274; 344, 346) that can be rotationally displaced about an axis,
- the transducer of the control device is mechanically bearing on an end of this lever in such a way as to rotationally displace it when the transducer is deformed between:
• a first state in which the excess of electrical charges present on the first terminal exceeds the first threshold, and
• a second state in which the excess of electrical charges present on the first terminal is below the first threshold, and
- at least one of the electrical contacts (240; 328) of the first switch is fixed with no degree of freedom onto the lever at a point closer to the axis of rotation than the point where the transducer bears, so as to be displaced by this lever from the open position to the closed position at the same time as the transducer is deformed from its second state to its first state.

5. Harvester according to any one of the preceding claims, in which the first converter comprises:
- a first electromechanical transducer (228; 314; 352) suitable for transforming a mechanical stress exerted on this electromechanical transducer into a generation of the excess of electrical charges collected by the collection electrical circuit, and
- a second transducer (230; 316; 356; 374, 238) fixed with no degree of freedom to the first electromechanical transducer, this second transducer being suitable for converting a variation of the energy to be harvested into a mechanical stress exerted on the electromechanical transducer.

6. Harvester according to Claim 5, in which the second transducer is a thermomechanical transducer (230; 316; 356; 374, 238) suitable for transforming a temperature variation into a mechanical deformation of this second transducer.

7. Harvester according to Claim 6, in which the thermomechanical transducer (230; 316; 356; 374, 238) comprises a material with shape memory.

8. Harvester according to Claim 5 and Claim 1, in which the same transducer (230; 316; 356; 374, 238) forms both the second transducer of the first converter (186) and the transducer of the control device.

9. Harvester according to Claim 5, in which the electromechanical transducer (72, 74; 196; 228; 314) of the first converter comprises a piezoelectric material.
